# FASCICULE DE BREVET EUROPEEN

(11) **EP 2 342 744 B1**
(45) Date de publication et mention de la délivrance du brevet: **05.09.2012**
(21) Numéro de dépôt: 09760241.1
(22) Date de dépôt: 29.10.2009
(51) Int. Cl.: H01L 21/762

(54) **PROCEDE DE FORMATION D'UNE COUCHE MONOCRISTALLINE DANS LE DOMAINE MICRO-ELECTRONIQUE**
VERFAHREN ZUR HERSTELLUNG EINER EINKRISTALLSCHICHT IN DER MIKROELEKTRONIK
PROCESS FOR FORMING A SINGLE-CRYSTAL FILM IN THE MICROELECTRONICS FIELD

(30) Priorité: 31.10.2008 FR 0806071
(43) Date de publication de la demande: 13.07.2011
(73) Titulaire: Commissariat à l'Énergie Atomique et aux Énergies Alternatives, 75015 Paris (FR)
(72) Inventeur: FOURNEL, Franck, F-38190 Villard-Bonnot (FR); SIGNAMARCHEIX, Thomas, F-38660 La Terrasse (FR); CLAVELIER, Laurent, F-38000 Grenoble (FR); DEGUET, Chrystel, F-38330 Saint Ismier (FR)
(74) Mandataire: Colombo, Michel
(86) Numéro de dépôt international: PCT/FR2009/052096
(87) Numéro de publication internationale: WO 2010/049657

(56) Documents cités:
- FR-A- 2 907 966
- US-A1- 2006 068 563
- US-B1- 6 251 754

## Description

L'invention concerne, dans le domaine de la micro-électronique (au sens le plus large du terme, incluant notamment les composants micro-mécaniques, micro-acoustiques, micro-optiques, etc.), la formation d'une couche monocristalline d'épaisseur quelconque.

En pratique la formation d'un composant micro-électronique implique diverses étapes faisant intervenir des couches de quelques nanomètres à quelques microns, voire dizaines de microns, dans lesquelles on forme tout ou partie de composants. Le matériau le plus utilisé dans ce domaine est le silicium, mais d'autres matériaux sont également utilisés, tels que le germanium (et ses alliages avec le silicium), le gallium et ses alliages (notamment l'arséniure de gallium), et d'autres éléments de la colonne IV du tableau périodique des éléments, voire des composés du type III-V, ou même II-VII. Un certain nombre de ces composants sont semi-conducteurs, ce qui explique qu'ils soient utilisés dans ce domaine de la micro-électronique.

La formation de tels composants micro-électroniques fait souvent intervenir une étape au cours de laquelle on forme une couche de silicium sur isolant, SOI en abrégé, c'est-à-dire une couche utile de silicium monocristallin sur une couche isolante qui définit l'une des faces de la couche ; depuis que le domaine micro-électronique s'est élargi à d'autres matériaux que le silicium, l'expression SOI a continué à être utilisée même lorsque la couche utile est en un matériau différent du silicium. Dans la suite, de nombreuses explications sont données dans le cas du silicium, mais il faut comprendre qu'elles se généralisent à d'autres matériaux du domaine micro-électronique.

Il existe plusieurs méthodes de fabrication d'une couche de type SOI.

Ainsi, il est connu d'oxyder thermiquement une plaquette de silicium (généralement en silicium monocristallin) afin de la transformer en tout ou partie en oxyde de silicium. Cette première plaquette est ensuite collée, notamment par collage moléculaire, sur une seconde plaquette de silicium (généralement en silicium monocristallin) ; il suffit ensuite d'amincir l'une ou l'autre des plaquettes pour obtenir une couche de silicium sur une couche d'oxyde silicium. Cet amincissement se fait en général au moyen d'un rodage suivi d'un polissage mécano-chimique. Une telle technique permet d'obtenir une couche de silicium dans une grande plage d'épaisseurs ; en particulier il est ainsi possible d'obtenir des couches aussi épaisses que l'on souhaite ; par contre, il s'avère difficile d'obtenir une bonne homogénéité d'épaisseur (typiquement une épaisseur ne variant que de +/- 10% par rapport à la valeur moyenne) en dessous de l'ordre de 5 microns d'épaisseur, étant rappelé qu'une plaquette, dans le domaine micro-électronique, est typiquement un disque ayant de l'ordre de 200 à 300 mm de diamètre, voire plus.

Lorsque l'on cherche à obtenir des films de silicium plus fins et bien contrôlés en épaisseur, il est connu d'utiliser la technique connue sous le nom « Smart Cut » ^{™} qui consiste, dans une version simplifiée, à implanter une plaquette de silicium oxydée en surface (avec une couche d'oxyde thermique de silicium qui a typiquement une épaisseur d'environ 145 nm) avec des ions hydrogène, à coller cette plaquette, par exemple par collage moléculaire, sur une autre plaquette de silicium, puis à provoquer une séparation au sein de l'ensemble ainsi obtenu, au niveau du pic d'implantation, par exemple au moyen d'un recuit thermique, en sorte d'obtenir un film mince de silicium sur une couche d'oxyde de silicium (à savoir la partie de la plaquette d'origine située entre la face d'implantation et le niveau du pic d'implantation). Le document US 6251 754 décrit une telle technique. Un avantage important de cette technique est que la plaquette d'origine, après séparation de ce film mince solidaire de la couche d'oxyde, peut être recyclé pour la formation d'autres films minces, ce qui est très intéressant en termes de coût par rapport à la technique précédente qui implique de consommer tout le substrat en dehors des couches voulues. Avec cette technique « Smart Cut » ^{™} on peut obtenir de faibles épaisseurs, entre quelques nanomètres et quelques microns avec une très bonne homogénéité (typiquement au plus égale à 1%). Toutefois, cette technique est mal adaptée pour l'obtention de couches de plus de 3 microns, puisque l'épaisseur de la couche hybride qui est séparée correspond à la profondeur d'implantation ; on comprend qu'il y a des limites à cette épaisseur, compte tenu de ce que les implantations d'ions se font généralement à au plus 200 KeV (ce qui correspond pour du silicium à un pic d'implantation autour de 2,5µm). Il est bien sûr possible de compléter la couche ainsi obtenue par croissance du film mince par épitaxie jusqu'à l'épaisseur désirée, mais le coût global devient alors supérieur à celui de la première technique précitée.

Une autre technique pour obtenir des couches de type SOI est connue sous le nom « Eltran » ®, qui consiste à réaliser, dans une plaquette de silicium, une couche de silicium poreux, puis à faire croître sur cette couche poreuse un film de silicium monocristallin par épitaxie. La surface de ce film est ensuite oxydée thermiquement, puis collée, par exemple par collage moléculaire, sur une deuxième plaquette de silicium, puis on provoque une fracture au sein de la couche poreuse en sorte de transférer le film de silicium monocristallin sur cette deuxième plaquette. On comprend que cette technique permet, comme la technique « Smart Cut »TM, l'obtention de films très minces avec une bonne homogénéité, ainsi que le recyclage de la partie de la plaquette d'origine dont le film mince s'est séparé. Toutefois, cette technique est relativement chère, compte tenu du prix des étapes de formation de porosité et d'épitaxie, de sorte que cette technique n'est en pratique utilisable que pour des épaisseurs inférieures à quelques microns.

Ainsi les trois techniques précitées ont, chacune, des limitations. La première ne permet de former que des couches épaisses (5 microns et au-delà, en pratique), tout en ayant un coût important du fait de la consommation de la partie non utilisée des plaquettes utilisées, tandis que les deux techniques suivantes consomment moins de matière, mais mettent en oeuvre des étapes relativement chères ; en outre elles sont limitées à des épaisseurs faibles (3 microns et moins).

Un objet de l'invention est de proposer un procédé de formation de couche mince permettant d'obtenir des couches monocristallines en une grande variété de matériaux du domaine de la micro-électronique, dans une large gamme d'épaisseurs possibles englobant les gammes de chacune des techniques précitée (donc dans une plage allant de quelques nanomètres à quelques dizaines, voire centaines, de microns), avec une bonne homogénéité à l'échelle d'une plaquette, typiquement sur au moins une dizaine de centimètres, et pour un coût modéré.

L'invention propose ainsi un procédé de formation d'une couche mince en un matériau donné, selon lequel,
- on prépare un premier substrat comportant, en surface, une couche amorphe et/ou polycristalline dudit matériau donné,
- on colle à ce premier substrat, par collage moléculaire hydrophobe, un second substrat comportant en surface une couche monocristalline de référence, ayant une orientation cristallographique donnée,
- on applique au moins à la couche amorphe et/ou polycristalline un traitement thermique adapté à provoquer la recristallisation en phase solide d'au moins une partie de cette couche amorphe et/ou polycristalline suivant l'orientation cristallographique de la couche de référence, cette couche de référence agissant en tant que germe de recristallisation, et
- on sépare la couche au moins en partie recristallisée vis-à-vis d'au moins une partie de la couche de référence.

Cette séparation a de préférence lieu vis-à-vis de la totalité (ou de la quasi-totalité) de cette couche de référence.

Il y a donc, selon l'invention, la transmission de l'information cristalline au travers d'une interface de collage et la séparation a avantageusement lieu le long (ou à proximité immédiate) de l'interface de collage.

Il est à noter que le procédé de l'invention ne nécessite pas la mise en oeuvre d'une étape d'implantation.

De manière préférée, l'on prépare le premier substrat en sorte que la couche amorphe et/ou polycristalline longe une couche sous-jacente adaptée à ne pas se recristalliser lors du traitement thermique, ce qui peut avoir comme avantage de bien délimiter la surface de la couche recristallisée du côté opposé à celui qui est collé au second substrat. Cette couche sera en général choisie en fonction de l'application visée : ce sera de préférence une couche diélectrique, par exemple une couche d'oxyde, telle qu'une couche d'un oxyde du matériau de la couche amorphe si l'on souhaite réaliser un SOI notamment.

Ainsi, l'invention utilise une couche temporairement rapportée à une couche amorphe et/ou polycristalline comme germe de recristallisation de cette dernière, ce qui permet une grande liberté dans le choix de la cristallographie à obtenir, en fonction des caractéristiques cristallographiques de la couche de référence formant germe.

On comprend que cette technique se distingue notamment de la technique « Eltran »® par le fait qu'elle n'implique pas la réalisation d'une épitaxie sur une couche poreuse (sans exclure, ni la formation d'une couche par épitaxie, par exemple une couche sacrificielle, ni la mise en oeuvre d'une couche poreuse, ainsi que cela est commenté ci-dessous) ; en outre, la continuité de réseau cristallin se fait au travers d'une interface de collage.

En fait, une autre option pour tenter de former des couches de type SOI par recristallisation consisterait à déposer du silicium amorphe sur une couche d'oxyde de silicium et de lui appliquer un traitement thermique suffisant pour en provoquer la recristallisation. Toutefois, l'expérience montre qu'une telle recristallisation spontanée ne se produirait qu'à une petite échelle, ne dépassant pas quelques dixièmes de centimètres le long de la couche d'isolant ; en d'autres termes, une recristallisation spontanée ne permettrait pas, en pratique, la formation d'une couche monocristalline sur une grande section comme celles des plaquettes utilisées dans la micro-électronique. Pour tenter de surmonter une telle difficulté, la technique dite ELOG ou ELO (Epitaxy lateral overgrowth) propose de réaliser des trous dans la couche d'oxyde avant le dépôt du silicium amorphe ; ainsi, lors du dépôt de ce silicium amorphe, une partie de celui-ci vient au contact du matériau situé sous cette couche isolante, par exemple du silicium monocristallin. Suivant les conditions de recristallisation, le caractère monocristallin du substrat situé sous la couche isolante peut « remonter » au travers des trous de cette couche isolante jusque dans la couche recristallisée, autour de ces trous. Mais cette germination de la recristallisation à partir des trous a pour inconvénient que cette recristallisation ne se produit pas de manière bien contrôlée à distance de ces trous (d'où une recristallisation polycristalline); par ailleurs, cette option a pour inconvénient que la couche isolante n'est plus continue, ce qui peut nuire à une bonne définition de l'épaisseur de la couche recristallisée à l'emplacement de ces trous.

On comprend que le collage moléculaire favorise le rôle de germe assuré par la couche de référence, alors qu'un collage par ajout de matière (colle ou résine notamment) constituerait un obstacle pour un tel rôle de germe (cela n'empêche pas la présence d'une fine couche sacrificielle, comme indiqué ci-dessous).

La couche de référence formant germe de recristallisation est avantageusement, sur une partie au moins de son épaisseur, poreuse, ce qui a l'avantage de constituer une zone « fragile » dans laquelle la séparation peut se faire par fracture. En d'autres termes, selon une option, la préparation du second substrat, le collage moléculaire et le traitement thermique de recristallisation sont tels que ce second substrat comporte, de préférence le long de l'interface, une zone dont la tenue mécanique est inférieure à celle de l'interface de collage.

Lorsque la couche de référence est dense et homogène (c'est-à-dire non poreuse), la séparation est avantageusement obtenue par décollement au niveau de l'interface de collage ou par la technologie « Smart Cut »^{™}.

Pour faciliter un tel décollement au niveau de l'interface de collage, le collage moléculaire est avantageusement réalisé en sorte que l'énergie de collage à l'interface entre les faces collées reste faible, même après le recuit de recristallisation de la couche amorphe. Pour ce faire, on peut prévoir de rugosifier la surface de l'une des surfaces formant l'interface, sur la couche amorphe ou sur la couche formant germe, voire de rugosifier chacune de ces surfaces, avec une rugosité suffisamment faible pour permettre d'obtenir un collage moléculaire et suffisamment forte pour permettre une séparation facile après recuit de recristallisation.

Une telle rugosification peut par exemple être obtenue en gravant la surface de la couche formant germe, ou celle de la couche amorphe. Dans le cas d'une couche en silicium monocristallin, cette gravure est avantageusement obtenue dans une solution d'eau, d'ammoniaque et d'eau oxygénée (H₂O, NH₄⁺/OH⁻ et H₂O₂) dans des proportions 1-1-5, à 70°C pendant 5 mn, voire 10 mn (il est à la portée de l'homme de métier de choisir une solution appropriée à chaque matériau à graver). On peut ainsi obtenir une rugosité qui, typiquement, est d'environ 0.2 nm RMS (root mean square) mesuré par AFM (mesure par force atomique) sur une surface de 5microns x 5 microns ; de manière préférée, cette rugosité est contrôlée en sorte d'être comprise entre 0.1 nm RMS et 1 nm RMS.

Au lieu de modifier la rugosité des couches destinées à être collées, on peut prévoir une couche sacrificielle entre ces deux surfaces, sous réserve que cette couche conserve l'information cristalline à transmettre et permette ainsi que la couche formant germe assure son rôle lors de la recristallisation. A titre d'exemple, cette couche sacrificielle peut être un alliage des deux matériaux constitutifs de la couche amorphe et/ou polycristalline et de la couche formant germe, qui est épitaxié sur la couche formant germe, par exemple du SiₓGe₍₁₋ₓ₎ dans le cas d'une couche amorphe en silicium collée à une couche formant germe en silicium ou en germanium. Dans le cas où l'on souhaite recristalliser un film amorphe de silicium par un germe monocristallin de silicium, il sera possible de déposer sur le germe une couche mince sacrificielle de SiGe. Cette couche devra être d'épaisseur inférieure à l'épaisseur critique (épaisseur jusqu'à laquelle du SiGe croît avec le paramètre de maille du silicium sous-jacent, conservant ainsi l'information cristalline du silicium ; pour du Si_{0,8}Ge_{0,2} sur Si, on se limitera typiquement à une épaisseur de 5nm). Après collage et recuit de recristallisation, pour obtenir la séparation, il suffit alors d'éliminer une grande partie du substrat germe, par exemple par rectification mécanique ou par fracture au niveau d'une zone fragile enterrée réalisée préalablement dans le substrat germe, puis de mettre en oeuvre une ou plusieurs solutions d'attaque sélective de tout type connu approprié pour éliminer la partie du germe résiduelle, s'il en existe, puis la couche sacrificielle de SiGe (une solution connue par exemple pour graver sélectivement le SiGe par rapport au silicium est HF/HNO₃).

Pour faciliter le décollement, on pourra prévoir également de limiter le budget thermique de recristallisation (qui tend en même temps à renforcer l'interface de collage). On peut par exemple envisager de recristalliser seulement une faible partie de l'épaisseur de la couche amorphe et/ou polycristalline, à partir de l'interface de collage, pour limiter la durée d'application du traitement de recristallisation, puis de procéder au décollement (tant que l'interface de collage a une tenue modérée) puis de poursuivre et compléter la recristallisation de la couche amorphe et/ou polycristalline par l'application d'un budget thermique complémentaire. Cela permet de limiter le budget thermique pré-décollement (et donc de garantir que la structure sera décollable) tout en transférant l'information cristalline « de l'autre coté » de l'interface de collage. Il est rappelé que la notion de budget thermique englobe à la fois la température d'un traitement et sa durée.

Une telle recristallisation en deux étapes de traitement, avec un premier traitement qui n'est adapté à provoquer la recristallisation que d'une partie (en pratique, une partie de l'épaisseur) de la couche amorphe et/ou polycristalline et, après séparation, l'application d'un second traitement thermique (voire de plusieurs traitements thermiques) adapté(s) à poursuivre et compléter la recristallisation de la couche amorphe et/ou polycristalline, a aussi, indépendamment de l'endroit où se fait la séparation, un avantage énergétique puisque le traitement thermique complémentaire n'a pas besoin d'être appliqué à la couche formant germe.

On comprend aisément que, bien que cela soit avantageux, il n'est pas nécessaire que la recristallisation soit obtenue, partout dans la couche à recristalliser, sur une même partie de l'épaisseur de cette couche ; il suffit que la partie de cette couche qui est recristallisée soit suffisamment importante pour servir de germe au reste de la couche, lors du traitement thermique postérieur à la séparation.

Il a été indiqué ci-dessus que le collage moléculaire de la couche amorphe et/ou polycristalline et de la couche formant germe est hydrophobe ; c'est en effet la meilleure façon (voire la seule) d'obtenir une bonne transmission, complète, de l'information cristalline au travers de l'interface de collage ; il a par contre été constaté que, si l'une des surfaces est hydrophile, l'oxyde présent à l'interface empêche une bonne transmission de cette information cristalline.

Lorsque la couche formant germe est poreuse, elle est en pratique formée à partir d'un monocristal (de silicium, par exemple, si l'on cherche à former une couche poreuse de silicium), mais d'une manière bien plus simple (et économique) que lorsqu'il faut assurer une compatibilité en surface avec une épitaxie, comme cela est requis dans la technique « Eltran » qui nécessite une porosité de surface relativement faible, ce qui oblige en général à gérer deux niveaux de porosité et à réaliser un recuit supplémentaire pour boucher la surface.

L'épaisseur de la couche formant germe est avantageusement comprise entre quelques nanomètres à plusieurs centaines de microns, de préférence supérieure à 1 micron.

Un intérêt de choisir, pour la couche amorphe et/ou polycristalline et pour la couche formant germe, des matériaux différents, est que l'on peut ainsi, si on le souhaite, provoquer la recristallisation de la couche amorphe et/ou polycristalline selon une cristallographie (notamment en ce qui concerne les paramètres de maille) imposée par la couche formant germe qui correspond à un état précontraint. C'est ainsi que, par exemple, l'utilisation de Si_{0.8}Ge_{0.2} relaxé comme germe pour une couche en silicium amorphe contribue à former une couche de silicium recristallisée en tension.

La couche sous-jacente, par exemple une couche diélectrique (voir ci-dessus), a avantageusement une épaisseur pouvant aller de quelques nanomètres à plusieurs microns.

Elle peut être formée à la surface d'une autre couche sous-jacente, cristalline ou non.

Il peut s'agir d'une couche d'oxyde, par exemple en un oxyde thermique obtenu par oxydation thermique d'un substrat porteur (par exemple une plaquette), par exemple de l'oxyde de silicium formé à la surface d'un substrat de silicium. En variante, cette couche sous-jacente peut être déposée sur un substrat porteur ce qui permet de choisir indépendamment les matériaux constitutifs de cette couche et du substrat porteur ; à titre d'exemple, ce substrat porteur peut être en quartz ou en silice fondue tandis que la couche sous-jacente est en oxyde de silicium déposé par exemple par PECVD.

Le matériau de cette couche sous-jacente peut, en fait, être choisi dans une large gamme de matériaux, du moment qu'il est compatible avec les étapes de recristallisation ; c'est ainsi qu'il peut, non seulement être un oxyde du matériau constitutif du substrat porteur ou du substrat de départ, mais aussi être un nitrure (par exemple de silicium, ou d'aluminium), être en un matériau choisi pour sa haute constante diélectrique (HfO₂, par exemple), ou être en diamant, etc. Elle peut être formée de plusieurs couches élaborées successivement.

On comprend que ce substrat porteur peut être réalisé en tout matériau approprié, différent ou au contraire identique à celui de la couche formant germe, du moment qu'il est compatible avec les étapes de recristallisation. Le choix d'un matériau différent de celui de la couche formant germe a pour avantage de pouvoir choisir pour ce substrat une caractéristique spécifique choisie, par exemple un coefficient thermique différent de celui de cette couche germe ; cela permet notamment de gérer une création de contraintes au sein de la structure (c'est-à-dire de l'ensemble des couches après assemblage). On peut également choisir le matériau constitutif de ce substrat en sorte qu'il soit transparent, souple, etc. C'est ainsi que ce substrat porteur ou ce substrat de départ peut être en germanium, en carbure de silicium, en verre, en quartz, en silice fondue, etc., selon les besoins.

Cette couche sous-jacente n'est pas nécessairement une couche formée sur un substrat porteur ou dans un substrat de départ ; cette couche sous-jacente peut en effet être suffisamment épaisse pour constituer en elle-même un substrat porteur pour la couche amorphe et/ou polycristalline ; c'est ainsi que, par exemple, la couche amorphe et/ou polycristalline peut être une couche de germanium sur un substrat de silicium, qui est collée à un second substrat en germanium formant germe. On peut aussi choisir, pour la couche amorphe et/ou polycristalline, le même matériau que celui du substrat sous-jacent ; dans ce cas, de manière avantageuse, on choisit pour la couche formant germe une orientation cristallographique différente de celle du substrat porteur, de manière à ce que la couche amorphe et/ou polycristalline recristallise avec une orientation différente de celle de son support ; à titre d'exemple, on peut obtenir une couche d'orientation <110> sur un substrat du même matériau mais d'orientation <100> en recristallisant une couche de silicium amorphe (et/ou polycristalline) avec un germe d'orientation <110>.

Il est à noter que le dépôt de la couche amorphe peut être réalisé, dans un four, sur plusieurs substrats ou plaquettes en même temps, à basse température et à pression atmosphérique, contrairement à une épitaxie qui se fait plaque à plaque à haute température et sous vide poussé. Ce traitement de dépôt sous forme amorphe est donc collectif et permet de gagner un temps très important par rapport à un dépôt par épitaxie. C'est aussi une technique simple à mettre en oeuvre, de sorte que son coût de fabrication est faible. L'épaisseur de la couche amorphe est aisée à contrôler, puisque l'épaisseur de cette couche peut être, à volonté, faible ou importante, selon le temps de dépôt dans le four. Des commentaires similaires peuvent être faits à propos d'une couche polycristalline.

Il a été indiqué que la couche à recristalliser est amorphe et/ou polycristalline (c'est-à-dire pas monocristalline) ; le cas d'une couche amorphe est d'un intérêt pratique important, mais il est des applications où l'invention peut être utilement appliquée à la recristallisation de couches polycristallines (en tout en partie, le reste étant amorphe non monocristallin), par exemple dans le domaine des applications solaires, où il est connu de former des lingots de polysilicium que l'on découpe ensuite ; il peut alors être utile de transformer le polysilicium de surface en silicium monocristallin.

Le recuit de recristallisation est avantageusement réalisé entre 200°C et 1300°C, pendant une durée comprise entre quelques fractions de secondes et quelques heures, dans le cas d'une couche amorphe de silicium.

Comme indiqué ci-dessus, ce recuit de recristallisation peut être effectué en deux étapes (ou plus), typiquement en réduisant la durée du traitement avant la séparation.

Il a été mentionné que la séparation réalisée après recristallisation peut se faire dans le second substrat, au sein de la couche germe (près de la couche recristallisée), notamment lorsque celle-ci est poreuse ou, en variante, par décollement à l'interface de collage (dont on comprend que cela a l'avantage de ne pas nécessiter l'élimination d'une partie résiduelle de la couche formant germe (et donc du second substrat)).

On comprend que, dans les deux cas, le second substrat peut être réutilisé pour de nouveaux cycles au cours desquels la zone superficielle de ce second substrat sert de germe pour la recristallisation.

La séparation de la couche formant germe peut être effectuée par l'insertion mécanique d'un outil (par exemple une lame), ou d'un fluide (notamment, gaz ou eau), ou par des ondes acoustiques, au moins au sein de la zone fragile constituée par (ou dans) la couche formant germe (lorsqu'elle est poreuse, au moins en partie, ou qu'on y a implanté des ions) ou par l'interface de collage (lorsque son énergie de collage est faible).

Après la séparation entre la couche recristallisée et la couche formant germe, on applique avantageusement un recuit thermique à cette couche recristallisée afin d'en éliminer les éventuels défauts cristallins encore présents (ce recuit est avantageusement réalisé à une température en général supérieure à la température à laquelle la recristallisation a été effectuée).

Des étapes de finition peuvent être utiles pour la structure SOI ainsi obtenue, afin d'obtenir notamment un bon état de surface en termes de rugosité, par exemple. Il peut ainsi s'agir d'étapes telles qu'un polissage mécano-chimique, des recuits sous atmosphère réductrice, sous vide...

Dans ce qui précède il a été implicitement indiqué que la couche formant germe était continue et homogène. Cela n'est pas nécessaire pour la mise en oeuvre de l'invention. C'est ainsi que l'invention peut être aussi mise en oeuvre avec une couche formant germe constituée par une couche discontinue composée de nanofils (c'est-à-dire des fils dont le diamètre est de l'ordre de grandeur du nanomètre, ou de quelques nanomètres, typiquement inférieur à 5 nanomètres), par exemple des nanofils de silicium entourés d'oxyde de silicium, ou encore en SiₓGe₍₁₋ₓ₎.

A titre d'exemple, dans le cas de couches formées de silicium, les nanofils de silicium sont avantageusement élaborés sur un substrat de silicium monocristallin de manière à ce qu'ils aient tous la même information cristalline (cf: « Kuiqing Peng, Ying Xu, Yin Wu, Yunjie Yan, Shuit-Tong Lee and Jing Zhu, small 2005, 1, N°11, 1062-1067 »). Le procédé mis en oeuvre est par exemple celui décrit dans :
- Allon I. Hochbaum, Rong Fan, Rongrui He and Peidong Yang, NANO LETTERS 2005, Vol 5, N°3, pp 457-460,
- Kuiqing Peng, Juejun Hu, Yunjie Yan, Yin Wu, Hui Fang, Ying Xu, Shuit-Tong Lee and Jing Zhu, Adv. Funct. Mater. 2006, 16, 387-394.

De préférence, on dépose ensuite une couche d'oxyde sur l'ensemble des nanofils et, après une étape de polissage mécano-chimique, on obtient une surface composée d'oxyde et de silicium cristallin (du fait de l'affleurement des fils) comme expliqué dans « Volker Schmidt, Heike Riel, Stephan Senz, Siegfried Karg, Walter Riess, and Ulrich Gösele, small 2006, 2, n°1, 85-88 ». On procède ensuite au collage hydrophobe sur une couche de silicium amorphe, puis à un recuit de recristallisation. La séparation s'effectue ensuite au sein de la couche composite oxyde/nanofil, de préférence, de façon mécanique et/ou chimique (dissolution de l'oxyde dans du HF par exemple). Afin de faciliter la séparation, il est possible de remplacer l'oxyde de silicium qui est autour des nanofils par une couche présentant une plus faible résistance mécanique, par exemple en HfO₂ ou un bicouche composé de HfO₂ et d'oxyde de silicium (la couche supérieure d'oxyde de silicium permettant de faciliter le polissage mécano-chimique pour l'obtention d'une surface plane nécessaire au collage moléculaire).

Comme indiqué précédemment à propos des couches formant germe, les nanofils peuvent être, non pas en silicium, mais en un autre matériau tel que le germanium si l'on veut recristalliser du germanium (selon la cristallographie habituelle du germanium).

Il est aussi possible de faire croître du Si₍₁₋ₓ₎Geₓ (x=0.2, par exemple) sur le sommet des nanofils de silicium, ce qui a notamment pour avantage d'obtenir du Si₍₁₋ₓ₎Geₓ avec un paramètre de maille relaxé et sans contrainte au sein du nanofil. Lors de la recristallisation de la couche amorphe (par exemple du silicium), c'est le paramètre des nanofils qui sert de germe, ce qui permet d'obtenir, après recristallisation et après séparation, un silicium avec un paramètre de maille correspondant à du Si₍₁₋ₓ₎Geₓ, donc avec une contrainte interne.

On comprend que l'intérêt d'utiliser des nanofils, plutôt qu'une couche homogène, pour former la couche formant germe est que la présence de plusieurs matériaux peut faciliter la séparation. Les nanofils permettent également de disposer facilement de matière relaxée.

Des objets, caractéristiques et avantages de l'invention ressortent de la description qui suit, donnée à titre d'exemple illustratif non limitatif, en regard des dessins annexés sur lesquels :
- la figure 1 est une vue en coupe d'un premier substrat comportant en surface une couche poreuse et destiné à la mise en oeuvre de l'invention selon un premier mode de réalisation,
- la figure 2 est une vue en coupe d'un second substrat comportant en surface une couche de référence,
- la figure 3 est une vue en coupe d'un assemblage, par collage moléculaire, des substrats des figures 1 et 2,
- la figure 4 est une vue en coupe de cet assemblage après un recuit de recristallisation,
- la figure 5 est une vue en coupe de cet assemblage en cours de séparation,
- la figure 6 est une vue en coupe du premier substrat après application d'éventuelles étapes de finition,
- la figure 7 est une vue en coupe d'un autre premier substrat comportant en surface une couche poreuse, destiné à la mise en oeuvre de l'invention selon un second mode de réalisation,
- la figure 8 est une vue en coupe d'un autre second substrat destiné à comporter en surface une couche de référence,
- la figure 9 est une vue en coupe de ce second substrat après une première étape de préparation,
- la figure 10 est une vue en coupe de ce second substrat après une seconde étape de préparation et assemblage au premier substrat de la figure 7, par collage moléculaire,
- la figure 11 est une vue en coupe de cet assemblage en cours de séparation,
- la figure 12 est une vue en coupe d'encore un autre premier substrat destiné à la mise en oeuvre de l'invention selon un troisième mode de réalisation,
- la figure 13 est une vue en coupe d'un assemblage de ce premier substrat de la figure 12 et d'un second substrat ayant subi un traitement de rugosification, et
- la figure 14 est une vue en coupe de cet assemblage en cours de séparation.

### Premier exemple de réalisation

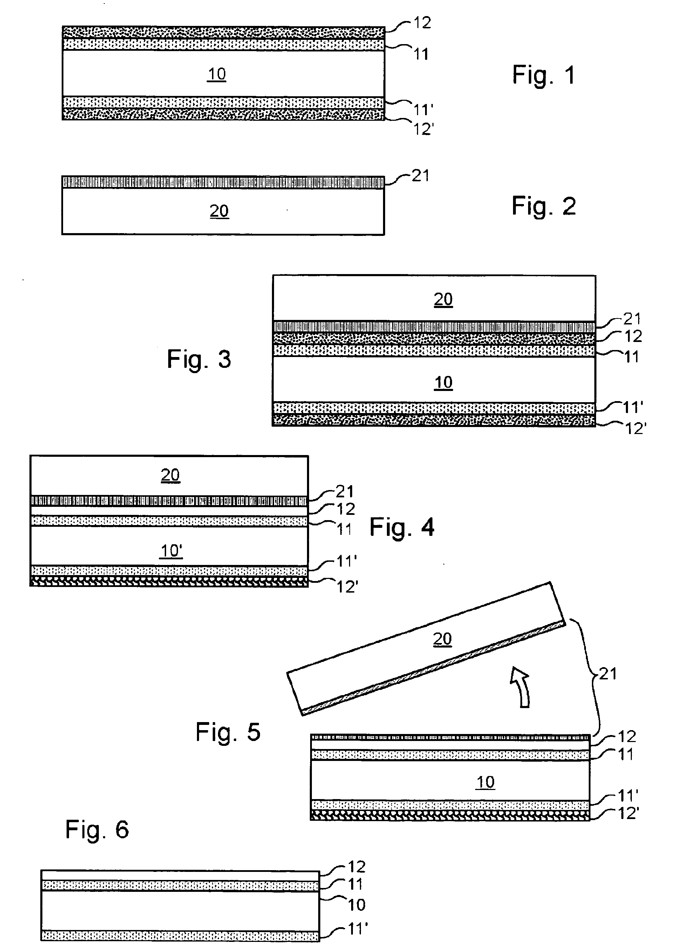

Les figures 1 à 6 décrivent les étapes d'un premier mode de mise en oeuvre du procédé de l'invention, pour la formation d'une couche de silicium monocristallin.

On commence par préparer un premier substrat comportant un substrat de support 10, ici constitué d'une plaquette de silicium monocristallin de 200 mm de diamètre, et, en surface, une couche amorphe 12 en un premier matériau, à savoir du silicium. Le substrat porteur a été préalablement oxydé thermiquement, par exemple au moyen d'un recuit sous vapeur d'eau, pendant 2h, pour élaborer une couche 11 de 400 nm d'épaisseur, en oxyde de silicium ; la couche de silicium, oxydée thermiquement, a ensuite fait l'objet d'un dépôt par CVD (chemical vapor deposition en anglais) à basse température (environ 400°C) de silicium amorphe jusqu'à former la couche 12 voulue, d'épaisseur ici de l'ordre de 50 nm.

Lorsque l'oxydation et le dépôt amorphe sont réalisés dans des fours de manière collective, le substrat, comme illustré figure 1, comporte une couche d'oxyde et une couche amorphe sur chacune de ses faces (repérées 11' et 12' en face inférieure), mais il faut comprendre qu'il suffirait que de telles couches 11 et 12 existent sur une seule des faces du substrat 10.

Par électrochimie, un second substrat 20 est, ici sur une partie seulement de son épaisseur sous une surface libre, rendu poreux, par exemple par traitement par une solution à base de HF pendant des conditions appropriées. Cette couche poreuse 21 a par exemple une épaisseur de 10 microns. Ce substrat 20 est avantageusement une plaquette similaire à la plaquette dont a été formé le premier substrat 10. On obtient ainsi la configuration de la figure 2.

Ce second substrat 20 est monocristallin, ici selon une orientation <001 >. Il s'agit par exemple d'un silicium de type n dopé à 1 Ohm.cm auquel on a appliqué une densité de courant de 400 mA.cm² sans éclairage en face arrière.

Après un traitement optionnel consistant ici en un traitement par du HF (en solution, ou en phase vapeur), les deux surfaces libres des premier et second substrats 10 et 20 (à savoir les surfaces libres des couches 12 et 21) sont collées par collage moléculaire hydrophobe (le collage moléculaire est parfois appelé « adhésion moléculaire »). On obtient ainsi la configuration de la figure 3.

On effectue ensuite un recuit thermique afin de provoquer la recristallisation en phase solide de la couche amorphe 12 en silicium monocristallin, selon les paramètres cristallins de la couche 21 qui constitue donc, à travers l'interface de collage moléculaire, une couche de référence formant germe de recristallisation.

Ce recuit peut consister par exemple en une rampe de température de 0,5°C/mn entre 200° et 1200°C..

En fait, ce recuit a non seulement pour effet de provoquer la recristallisation de la couche amorphe, mais aussi de consolider l'interface de collage moléculaire.

On peut noter à la figure 4 que, puisque le premier substrat 10 est muni d'une couche amorphe sur chacune de ses faces, le traitement de recuit a provoqué la recristallisation non seulement de la couche 12 sur sa face supérieure, mais aussi de la couche 12' sur sa face inférieure. Toutefois, puisque cette couche 12' n'a été en contact avec aucune couche formant germe, elle s'est recristallisée sous forme polycristalline.

Ainsi que cela est schématisé à la figure 5, on provoque ensuite, par tout moyen approprié, la séparation de la couche recristallisée (couche monocristalline 12) vis-à-vis de la couche 21 qui lui a servi de référence pour la recristallisation.

Dans l'exemple ici considéré, cette séparation se fait au sein de la couche poreuse 21, compte tenu de ce que, en l'absence de précautions particulières pour éviter une trop forte consolidation de l'interface de collage (voir le troisième exemple ci-dessous), cette couche poreuse est en pratique mécaniquement plus fragile que l'interface de collage.

Après cette séparation, le second substrat 20 ne comporte plus qu'une partie de la couche poreuse 21, tandis que l'autre partie de cette couche poreuse se trouve solidaire, du fait du collage moléculaire, du premier substrat 10+11+12.

Un traitement de finition est alors appliqué, par exemple sous la forme d'un polissage mécano-chimique ou ionique, en sorte d'éliminer cette partie résiduelle de la couche poreuse ; on peut en outre, en fonction des besoins, éliminer, sur la face opposée du premier substrat, la couche 12' recristallisée sous forme polycristalline. On obtient ainsi un premier substrat modifié, comportant une couche 12 monocristalline ayant des caractéristiques cristallines (dimensions et orientation) fixées par celles de la couche 21 choisie en tant que couche de référence pour servir de germe de recristallisation.

Quant au second substrat 20, il peut être recyclé en pratique après élimination, par exemple par retrait chimique, des restes de la couche poreuse ; on peut ensuite former sur ce substrat une nouvelle couche poreuse destinée à servir de germe de recristallisation d'une couche amorphe d'un nouveau premier substrat, selon les mêmes paramètres de cristallisation, ou non.

Le recuit thermique de recristallisation peut, en variante, être effectué en deux étapes (voire plus), dont une première étape suffisante pour provoquer la recristallisation d'une partie, éventuellement faible, de l'épaisseur de la couche amorphe à partir de l'interface. Après séparation, la recristallisation du reste de la couche amorphe peut être obtenue, en une ou plusieurs étapes, en utilisant la partie recristallisée comme germe pour ce reste de la couche amorphe. La première étape est par exemple une rampe plus rapide que celle mentionnée ci-dessus.

En variante, les couches 12 et 12' sont initialement sous forme polycristall ine.

Selon encore une autre variante, la couche formant germe est préalablement fragilisée par une implantation d'ions appropriée, de manière à localiser la future séparation.

### Second exemple de réalisation

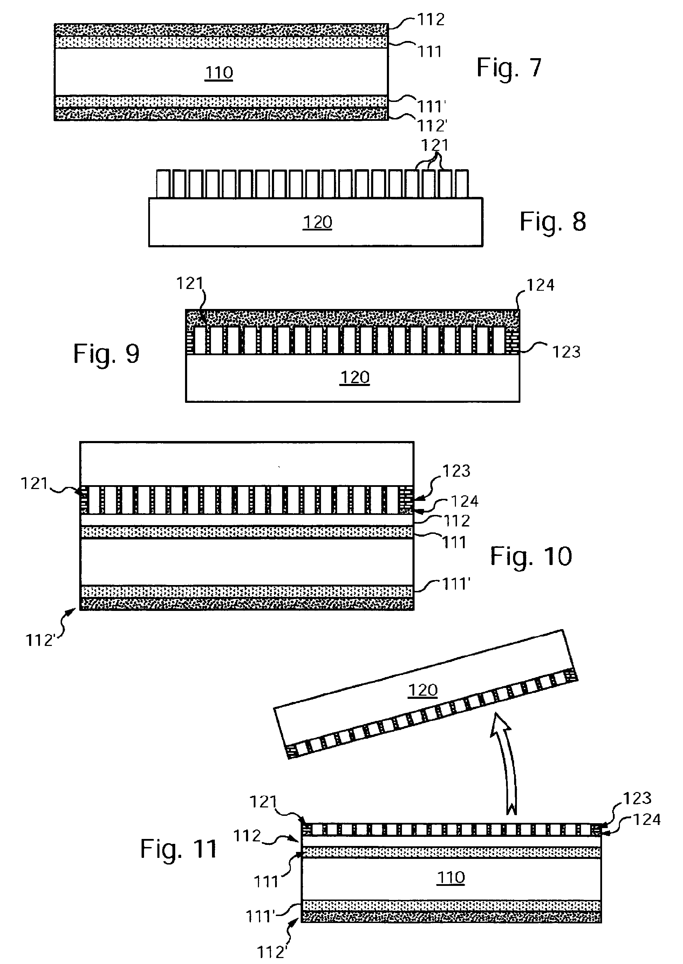

Les figures 7 à 11 décrivent un autre mode de mise en oeuvre du procédé de l'invention ; sur ces figures, les éléments qui sont analogues à ceux des figures 1 à 6 sont désignés par des chiffres de référence qui se déduisent de ceux de ces figures 1 à 6 par addition du nombre 100.

C'est ainsi que ce second exemple de mise en oeuvre de l'invention commence par la préparation d'un premier substrat 110 suivant les mêmes opérations que celles ayant abouti au premier substrat 10 du premier exemple, à savoir :
- oxydation thermique d'une plaquette 110 de silicium monocristallin de 200 nm de diamètre, en sorte de former une couche d'arrêt 111 constituée par l'oxyde de l'élément constitutif du substrat porteur,
- dépôt sur la couche d'oxyde d'une couche de silicium amorphe, par exemple de 50 nm d'épaisseur.

De même que dans le premier exemple, la plaquette 110 est longée sur chacune de ses faces par une couche d'oxyde 111 ou 111' puis par une couche de sil icium amorphe 112 ou 112'.

Sur une deuxième plaquette 120, ici en silicium, par exemple identique à la plaquette de support 20 du premier exemple, on réalise des nanofils de silicium monocristalin 121 (donc sans couche intermédiaire entre ces nanofils et cette plaquette). Ces nanofils sont par exemple réalisés de la manière décrite dans « Allon I. Hochbaum, Rong Fan, Rongrui He and Peidong Yang, NANO LETTERS 2005 Vol 5, N°3, pp. 457-460 », ou dans « Kuiqing Peng, Juejun Hu, Yunjie Yan, Yin Wu, Hui Fang, Ying Xu, ShuitTong Lee and Jing Zhu, Funct. Mater. 2006, 16 387-394 ». On obtient ainsi la configuration de la figure 8.

Il est à noter que ces fils monocristallins, réalisés sur la plaquette 120, ont tous la même orientation, à savoir celle qui leur a été conférée par la plaquette sous-jacente ; il en découle que, conjointement, ces nanofils forment une couche monocristalline, quoique discontinue.

Ces nanofils sont parallèles les uns aux autres et leur écartement est avantageusement inférieur à celui de leurs dimensions transverses, de sorte que cette couche discontinue 121 est en très grande majorité formée par le matériau constitutif de ces nanofils, typiquement à plus de deux tiers, voire plus des trois-quarts.

Ainsi que cela est représenté à la figure 9, on dépose un premier oxyde 123 entre les nanofils, puis un second oxyde 124 qui recouvre les nanofils. Dans l'exemple représenté, le premier oxyde est de l'oxyde d'hafnium, HfO₂, tandis que le second oxyde est de l'oxyde de silicium.

De manière à permettre aux nanofils d'agir en tant que germes de recristallisation, on applique à la structure de la figure 9 un traitement de planarisation visant à mettre à nu ces nanofils 121.

La tranche de ces nanofils ainsi mise à nu, conjointement avec l'oxyde 124 situé entre ces nanofils, est alors assemblée, par collage moléculaire, hydrophobe de manière à garantir une bonne transmission de l'information cristallographique, à la surface libre de la couche amorphe 112, puis on applique à la structure assemblée un traitement de recuit, par exemple identique à celui appliqué dans le premier exemple, adapté à provoquer la recristallisation de la couche 112 (et de la couche 112' lorsqu'elle existe) ; compte tenu du collage moléculaire entre la couche amorphe 112 et les nanofils en silicium monocristallin, cette couche amorphe recristallise suivant les paramètres cristallins de ces nanofils, suivant leur cristallographie commune. Cela est schématisé à la figure 10.

On peut noter sur cette figure 10 que, dans l'exemple représenté, le second substrat comporte deux oxydes entre les nanofils, respectivement notés 123 et 124, entre lesquels peuvent être réparties les rôles de germes de recristallisation et de zone fragile pour la séparation ultérieure (voir ci-dessous).

Ainsi que cela est représenté à la figure 11, on applique alors un traitement de séparation, ici au sein de la couche (discontinue) formée d'oxyde d'hafnium qui est moins mécaniquement résistante que la couche d'oxyde de silicium et que, à moins de précautions particulières lors du collage moléculaire, l'interface résultant de ce collage.

Comme dans le premier exemple, on peut ensuite éliminer la partie des nanofils et de l'oxyde de silicium qui est solidaire du premier substrat par attaque chimique spécifique, par exemple par attaque humide HF.

En variante, la séparation peut être obtenue par attaque chimique sélective du matériau longeant les nanofils et l'interface de collage, ici l'oxyde de silicium par une attaque par HF par exemple, en sorte de faciliter la fracture au sein des nanofils, voire entre les extrémités de ces nanofils et la couche recristallisée.

Selon encore une autre variante, on rugosifie l'une des surfaces destinées à être collées de manière moléculaire, par exemple par la formation d'une surgravure dans l'oxyde de silicium du second substrat, ce qui a pour effet que le collage moléculaire est sélectivement réalisé en regard des nanofils, lesquels constituent ainsi des ponts ou piliers de connexion entre les substrats ; le fait de faire ainsi ressortir les motifs de silicium a pour avantage de localiser le collage moléculaire à une partie bien contrôlée de la surface libre du second substrat, ce qui permet de contrôler la tenue mécanique de l'interface de collage, et donc de délimiter le niveau d'énergie qu'il faut fournir pour obtenir une séparation au niveau de cet interface de collage.

Une telle surgravure est, par exemple réalisée par une attaque par du HF 1% dans le cas d'un oxyde de silicium (une attaque pendant 2 minutes enlève environ 12 nm d'oxyde sans attaquer de manière significative le silicium des nanofils).

Comme dans le premier exemple, le recuit de recristallisation peut être réalisé en deux étapes séparées par l'étape de séparation ; de même, la couche à recristalliser peut être initialement polycristalline.

### Troisième exemple de réalisation

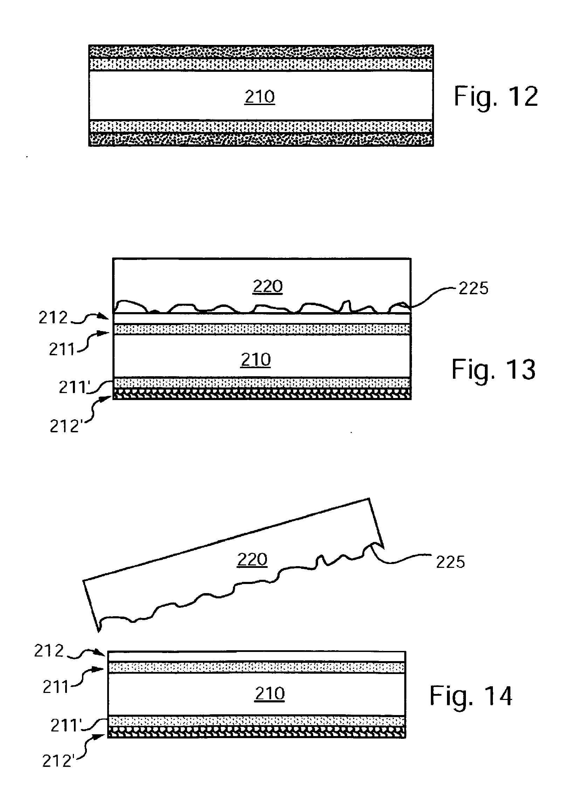

Les figures 12 à 14 représentent de manière schématique un troisième mode de mise en oeuvre du procédé de l'invention. Sur ces figures les éléments analogues à ceux des figures 1 à 6 sont désignés par les signes de référence qui se déduisent de ceux utilisés sur ces figures par l'addition du nombre 200.

Dans cet exemple, on prépare un premier substrat 210 de la même manière que les premiers substrats 10 et 110 des exemples précédents. Ce premier substrat comporte donc un substrat porteur 210 longé, sur ses deux faces, par une couche d'oxyde 211 et 211', ainsi que par une couche de silicium amorphe 212 et 212'.

On applique alors à la surface libre d'un second substrat 220, qui peut être la surface libre de ce second substrat lui-même (c'est-à-dire sans couche rapportée), un traitement de rugosification de manière à dégrader, de manière contrôlée, la tenue mécanique de l'interface qui va être obtenu par collage moléculaire hydrophobe (pour une transmission optimale de l'information cristallographique). A titre d'exemple, lorsque ce second substrat est en silicium, cette rugosification est obtenue par attaque par une solution d'eau, d'ammoniaque et d'eau oxygénée (H₂O, NH₄⁺/OH⁻ et H₂O₂) dans des proportions 1-1-5, à 70°C pendant 10 mn, ce qui permet d'obtenir une rugosité de 0.2 nm RMS environ (mesurée par AFM sur une zone de 5 microns x 5 microns).

Cette rugosité obtenue est représentée, sous forme très exagérée, sous la référence 225 à la figure 13.

Il est aussi possible, en variante ou en complément, de modifier la rugosité de la surface libre de la couche amorphe.

Les rugosités des deux surfaces ne doivent pas, en pratique, dépasser 0.4 nm RMS, de manière à ne pas gêner le collage moléculaire de manière significative.

Il est possible de contrôler la rugosité de surface en alternant des traitements lissants (tels que le polissage mécano-chimique CMP), des recuits sous ultra-vide à haute température (>1000°C), ou des recuits sous pression partielle d'hydrogène à haute température (>600°C) et des traitements rugosifiants, comme celui mentionné ci-dessus à base d'ammoniaque, ou des attaques chimiques à base de HF dilué, de HF/HNO₃, de HF/CrO₃, de TMAH (Tetra Methyl Ammonium Hydroxide), ou de HF/CH₃COOOH (per-acétate). Bien évidement les traitements thermiques à haute température ne doivent pas être appliqués à la couche amorphe pour ne pas la recristalliser sous forme polycristalline avant le collage moléculaire.

On colle ensuite, par un collage moléculaire de type hydrophobe, les deux surfaces. Dans le cas du silicium il s'agit de terminer la préparation des surfaces, par exemple par une attaque chimique avec une solution à base de HF afin d'obtenir une fonctionnalisation de surface de type Si-H. Les deux surfaces, exemptes d'oxyde de silicium, et dont les terminaisons sont de type Si-H sont ensuite mises en contactes.

On applique un budget thermique (défini par au moins un couple durée/température) apte, comme précédemment, à provoquer, ou au moins commencer, la recristallisation.

On comprend que la séparation ultérieure (voir la figure 14) peut alors être obtenue, à l'interface de collage, par exemple par application d'un outil mécanique, tel qu'une lame que l'on cherche à insérer au niveau de cette interface. On peut aussi envisager d'autres types de séparations, en appliquant par exemple un effort de flexion à la structure, ou en envoyant un jet de liquide ou de gaz localisé, ou au moyen d'ultra-sons, notamment.

Après la séparation, on peut appliquer un autre budget thermique pour finir la recristallisation monocristalline, dans le cas où celle-ci n'a fait que commencer pendant le premier budget thermique.

La finition du premier substrat est simplifiée par rapport aux exemples précédents par le fait qu'il n'est plus nécessaire d'éliminer une partie résiduelle du second substrat.

On comprend de ce qui précède que l'invention peut s'appliquer à d'autres matériaux, notamment le germanium ou des alliages silicium-germanium, mais aussi des alliages des colonnes III-V du tableau périodique des éléments, en adaptant les conditions de collage et de traitement de recristallisation, voire de traitement des surfaces, conformément aux connaissances générales de l'homme de métier.

Dans les exemples ci-dessus, la couche amorphe qui est recristallisée a une épaisseur de quelques dizaines de nanomètres, mais il faut bien comprendre que l'invention s'applique à la formation de couches monocristallines bien plus épaisses, selon les besoins, sans avoir les limitations des technologies connues ; c'est ainsi que l'invention permet notamment la formation de couches monocristallines de plusieurs microns d'épaisseur, voire supérieures à une dizaine de microns.

## Revendications

1. Procédé de formation d'une couche mince en un matériau donné, selon lequel,
- on prépare un premier substrat comportant, en surface, une couche amorphe et/ou polycristalline dudit matériau donné,
- on colle à ce premier substrat, par collage moléculaire hydrophobe, un second substrat comportant en surface une couche monocristalline de référence, ayant une orientation cristallographique donnée,
- on applique, au moins à la couche amorphe et/ou polycristalline, un traitement thermique adapté à provoquer la recristallisation en phase solide d'au moins une partie de cette couche amorphe et/ou polycristalline suivant l'orientation cristallographique de la couche de référence, cette couche de référence agissant en tant que germe de recristallisation, et
- on sépare la couche au moins en partie recristallisée vis-à-vis d'au moins une partie de la couche de référence.

2. Procédé selon la revendication 1, **caractérisé en ce que** l'on prépare le premier substrat en sorte que la couche amorphe et/ou polycristalline longe une couche sous-jacente adaptée à ne pas se recristalliser lors du traitement thermique.

3. Procédé selon la revendication 2, **caractérisé en ce que** la couche sous-jacente est une couche d'oxyde.

4. Procédé selon la revendication 3, **caractérisé en ce que** la couche sous-jacente est une couche d'un oxyde thermique du matériau de la couche amorphe et/ou polycristalline.

5. Procédé selon l'une quelconque des revendications 1 à 4, **caractérisé en ce que** le dépôt de la couche amorphe et/ou polycristalline est conduit, de manière collective, par dépôt d'un même matériau sur plusieurs substrats au sein d'un même four.

6. Procédé selon l'une quelconque des revendications 1 à 5, **caractérisé en ce que** la préparation du second substrat, le collage moléculaire et le traitement thermique de recristallisation sont tels que ce second substrat comporte, le long de l'interface, une zone dont la tenue mécanique est inférieure à celle de l'interface de collage.

7. Procédé selon l'une quelconque des revendications 1 à 6, **caractérisé en ce que** la couche de référence est poreuse, sur une partie au moins de son épaisseur, et la séparation est provoquée au sein de cette zone poreuse.

8. Procédé selon l'une quelconque des revendications 1 à 6, **caractérisé en ce que** l'on applique un traitement de surface à l'une des faces destinées à être collées par collage moléculaire en sorte d'en augmenter la rugosité, et on provoque la séparation à l'interface de collage ainsi obtenue.

9. Procédé selon la revendication 8, **caractérisé en ce que** la rugosité ainsi formée est comprise entre 0.1 nm RMS et 1 nm RMS.

10. Procédé selon l'une quelconque des revendications 1 à 6, **caractérisé en ce que** la couche de référence est préparée sous la forme d'un réseau de nanofils monocristallins ayant une même orientation et de mêmes dimensions cristallographiques.

11. Procédé selon la revendication 10, **caractérisé en ce que** la couche de référence comporte, entre les nanofils, au moins une couche longeant l'interface de collage moléculaire et une couche ayant une tenue mécanique inférieure à celle de cette couche longeant l'interface ainsi qu'à celle de cette interface.

12. Procédé selon l'une quelconque des revendications 1 à 11, **caractérisé en ce que** la couche de référence est réalisée en un matériau différent de celui de la couche amorphe et/ou polycristalline, grâce à quoi la couche amorphe et/ou polycristalline recristallise dans un état contraint.

13. Procédé selon l'une quelconque des revendications 1 à 12, **caractérisé en ce que** la couche amorphe et/ou polycristalline et la couche de référence sont en des matériaux choisis parmi le silicium, le germanium et leurs alliages.

14. Procédé selon l'une quelconque des revendications 1 à 13, **caractérisé en ce que** le traitement thermique de recristallisation n'est adapté à provoquer la recristallisation que d'une partie de la couche amorphe et/ou polycristalline et, après séparation, on applique un second traitement thermique adapté à compléter la recristallisation de la couche amorphe et/ou polycristalline.

15. Procédé selon l'une quelconque des revendications 1 à 14, **caractérisé en ce que** l'on applique un traitement de recuit, après la séparation, en sorte d'éliminer les éventuels défauts de cristallisation résultant de la recristallisation.

## Claims

1. Process for forming a thin film of a given material, according to which:
- a first substrate, having an amorphous and/or polycrystalline film of the said given material on the surface, is prepared,
- a second substrate, having a monocrystalline reference film of given crystallographic orientation on the surface, is bonded to this first substrate by hydrophobic molecular adhesion,
- a heat treatment, adapted to cause solid-phase recrystallization of at least a part of this amorphous and/or polycrystalline film along the crystallographic orientation of the reference film, is applied at least to the amorphous and/or polycrystalline film, this reference film acting as a recrystallization seed, and
- the at least partially recrystallized film is separated from at least a part of the reference film.

2. Process according to Claim 1, **characterized in that** the first substrate is prepared in such a way that the amorphous and/or polycrystalline film bears on an underlying film adapted not to recrystallize during the heat treatment.

3. Process according to Claim 2, **characterized in that** the underlying film is an oxide film.

4. Process according to Claim 3, **characterized in that** the underlying film is a film consisting of a thermal oxide of the material of the amorphous and/or polycrystalline film.

5. Process according to any one of Claims 1 to 4, **characterized in that** the deposition of the amorphous and/or polycrystalline film is carried out collectively by deposition of the same material on a plurality of substrates in the same furnace.

6. Process according to any one of Claims 1 to 5, **characterized in that** the preparation of the second substrate, the molecular adhesion and the heat treatment for recrystallization are such that, along the interface, this second substrate comprises a zone whose mechanical strength is less than that of the adhesion interface.

7. Process according to any one of Claims 1 to 6, **characterized in that** the reference film is porous over at least a part of its thickness, and the separation is induced in this porous zone.

8. Process according to any one of Claims 1 to 6, **characterized in that** a surface treatment is applied to one of the faces intended to be bonded by molecular adhesion, in such a way as to increase its roughness, and the separation is induced at the adhesion interface thus obtained.

9. Process according to Claim 8, **characterized in that** the roughness thus formed is between 0.1 nm RMS and 1 nm RMS.

10. Process according to any one of Claims 1 to 6, **characterized in that** the reference film is prepared in the form of a network of monocrystalline nanofilaments having the same orientation and the same crystallographic dimensions.

11. Process according to Claim 10, **characterized in that**, between the nanofilaments, the reference film comprises at least a film bearing on the molecular adhesion interface and a film having a mechanical strength less than that of both this film bearing on the interface and this interface.

12. Process according to any one of Claims 1 to 11, **characterized in that** the reference film is produced from a material different to that of the amorphous and/or polycrystalline film, by virtue of which the amorphous and/or polycrystalline film recrystallizes in a strained state.

13. Process according to any one of Claims 1 to 12, **characterized in that** the amorphous and/or polycrystalline film and the reference film consist of material selected from silicon, germanium and their alloys.

14. Process according to any one of Claims 1 to 13, **characterized in that** the heat treatment for recrystallization is adapted to cause recrystallization of only a part of the amorphous and/or polycrystalline film, and a second heat treatment adapted to complete the recrystallization of the amorphous and/or polycrystalline film is applied after separation.

15. Process according to any one of Claims 1 to 14, **characterized in that** an annealing treatment is applied after the separation, in such a way as to eliminate the possible crystallization defects resulting from the recrystallization.

## Patentansprüche

1. Verfahren zum Bilden einer dünnen Schicht aus einem gegebenen Material, wobei
- ein erstes Substrat vorbereitet wird, das auf der Oberfläche eine amorphe und/oder polykristalline Schicht aus dem gegebenen Material aufweist,
- auf dieses Substrat durch hydrophobes molekulares Kleben ein zweites Substrat geklebt wird, das auf der Oberfläche eine monokristalline Referenzschicht aufweist, die eine gegebene kristallographische Orientierung besitzt,
- wenigstens auf die amorphe und/oder polykristalline Schicht eine Wärmebehandlung angewendet wird, die dafür ausgelegt ist, die Rekristallisation in der festen Phase wenigstens eines Teils dieser amorphen und/oder polykristallinen Schicht in der kristallographischen Orientierung der Referenzschicht hervorzurufen, wobei diese Referenzschicht als Rekristallisationskeim wirkt, und
- die wenigstens teilweise rekristallisierte Schicht von wenigstens einem Teil der Referenzschicht getrennt wird.

2. Verfahren nach Anspruch 1, **dadurch gekennzeichnet, dass** das erste Substrat in der Weise vorbereitet wird, dass die amorphe und/oder polykristalline Schicht längs einer darunter liegenden Schicht verläuft, die dafür ausgelegt ist, bei der Wärmebehandlung nicht zu rekristallisieren.

3. Verfahren nach Anspruch 2, **dadurch gekennzeichnet, dass** die darunter liegende Schicht eine Oxidschicht ist.

4. Verfahren nach Anspruch 3, **dadurch gekennzeichnet, dass** die darunter liegende Schicht eine Schicht eines thermischen Oxids des Materials der amorphen und/oder polykristallinen Schicht ist.

5. Verfahren nach einem der Ansprüche 1 bis 4, **dadurch gekennzeichnet, dass** die Ablagerung der amorphen und/oder polykristallinen Schicht insgesamt durch Ablagerung desselben Materials auf mehreren Substraten im selben Ofen ausgeführt wird.

6. Verfahren nach einem der Ansprüche 1 bis 5, **dadurch gekennzeichnet, dass** die Vorbereitung des zweiten Substrats, das molekulare Kleben und die Rekristallisations-Wärmebehandlung derart sind, dass dieses zweite Substrat längs der Grenzfläche eine Zone aufweist, deren mechanische Festigkeit geringer als jene der Klebegrenzfläche ist.

7. Verfahren nach einem der Ansprüche 1 bis 6, **dadurch gekennzeichnet, dass** die Referenzschicht wenigstens auf einem Teil ihrer Dicke porös ist und die Trennung innerhalb dieser porösen Zone hervorgerufen wird.

8. Verfahren nach einem der Ansprüche 1 bis 6, **dadurch gekennzeichnet, dass** auf eine der Flächen, die durch molekulares Kleben verklebt werden sollen, eine Oberflächenbehandlung angewendet wird, derart, dass die Starrheit erhöht wird, und dass die Trennung der auf diese Weise erhaltenen Klebegrenzfläche hervorgerufen wird.

9. Verfahren nach Anspruch 8, **dadurch gekennzeichnet, dass** die so geschaffene Starrheit im Bereich von 0,1 nm RMS bis 1 nm RMS liegt.

10. Verfahren nach einem der Ansprüche 1 bis 6, **dadurch gekennzeichnet, dass** die Referenzschicht in Form eines Netzes aus monokristallinen Nanofäden vorbereitet wird, das dieselbe Orientierung und dieselben kristallographischen Abmessungen besitzt.

11. Verfahren nach Anspruch 10, **dadurch gekennzeichnet, dass** die Referenzschicht zwischen den Nanofäden wenigstens eine Schicht aufweist, die längs der molekularen Klebegrenzfläche verläuft, und eine Schicht aufweist, die eine mechanische Festigkeit besitzt, die geringer ist als jene dieser Schicht, die längs der Grenzfläche verläuft, und kleiner als jene dieser Grenzfläche.

12. Verfahren nach einem der Ansprüche 1 bis 11, **dadurch gekennzeichnet, dass** die Referenzschicht aus einem Material hergestellt wird, das von jenem der amorphen und/oder polykristallinen Schicht verschieden ist, wodurch die amorphe und/oder polykristalline Schicht in einem erzwungenen Zustand rekristallisiert.

13. Verfahren nach einem der Ansprüche 1 bis 12, **dadurch gekennzeichnet, dass** die amorphe und/oder polykristalline Schicht und die Referenzschicht aus Materialien bestehen, die aus Silicium, Germanium und ihren Legierungen gewählt sind.

14. Verfahren nach einem der Ansprüche 1 bis 13, **dadurch gekennzeichnet, dass** die Rekristallisations-Wärmebehandlung dafür ausgelegt ist, die Rekristallisation nur in einem Teil der amorphen und/oder polykristallinen Schicht hervorzurufen, wobei nach der Trennung eine zweite Wärmebehandlung angewendet wird, die dafür ausgelegt ist, die Rekristallisation der amorphen und/oder polykristallinen Schicht zu vervollständigen.

15. Verfahren nach einem der Ansprüche 1 bis 14, **dadurch gekennzeichnet, dass** nach der Trennung eine Kühlungsbehandlung angewendet wird, derart, dass eventuelle Kristallisationsfehler, die sich aus der Rekristallisation ergeben, beseitigt werden.
